(19) Europäisches Patentamt
European Patent Office
Office européen des brevets

(11) **EP 4 246 600 A1**

(12) **EUROPEAN PATENT APPLICATION**
published in accordance with Art. 153(4) EPC

(43) Date of publication:
**20.09.2023 Bulletin 2023/38**

(51) International Patent Classification (IPC):
**H01L 33/50** (2010.01)    **H01L 33/60** (2010.01)

(21) Application number: **21892283.9**

(52) Cooperative Patent Classification (CPC):
**H01L 33/50; H01L 33/60**

(22) Date of filing: **09.11.2021**

(86) International application number:
**PCT/KR2021/016222**

(87) International publication number:
**WO 2022/103115 (19.05.2022 Gazette 2022/20)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.11.2020  KR 20200151356**

(71) Applicant: **Seoul National University R & DB
Foundation
Seoul 08826 (KR)**

(72) Inventors:
• **JEON, Heon Su
  Seoul 08826 (KR)**
• **LEE, Tae Yun
  Seoul 08826 (KR)**

(74) Representative: **AWA Sweden AB
Box 5117
200 71 Malmö (SE)**

(54) **RESONANT CAVITY STRUCTURE INCLUDING WAVELENGTH CONVERSION MATERIAL**

(57)    A resonant cavity structure includes an upper layer in which first dielectric layers and second dielectric layers having different refractive indices are alternately stacked, a lower layer in which the first dielectric layers and the second dielectric layers are alternately stacked, and a cavity formed between the upper layer and the lower layer, wherein the cavity includes a wavelength conversion material that absorbs light having a first wavelength and emits light having a second wavelength different from the first wavelength, the resonant cavity structure is designed so that resonance occurs in the cavity at the first wavelength, and is provided so that an excitation light of the first wavelength is incident from below the lower layer.

FIG. 1

EP 4 246 600 A1

# Description

## Technical Field

Embodiments of the present disclosure relate to a resonant cavity structure including a wavelength conversion material such as, for example, a phosphor.

## Background Art

Recently, light emitting diode (LED) market size continues to increase in various fields such as lighting and display. In particular, phosphor for color conversion may be used indispensably for white LEDs. The phosphor is a substance that absorbs light of high energy (i.e., shorter wavelength) and emits light of lower energy (i.e., longer wavelength). So far, the focus has been mainly on the development of fluorescent materials.

Accordingly, when an optical structure that may increase color conversion efficiency of any fluorescent material without being limited to a specific material is developed, it is expected that there will be a lot of demand in various fields requiring color conversion, such as lighting or displays.

## Disclosure

## Technical Problem

A purpose of the present disclosure is to provide an optical structure that may improve color conversion efficiency of various wavelength conversion materials, which has been devised to improve the above problems. Specifically, the purpose of the present disclosure is to provide a resonant cavity structure containing a wavelength conversion material.

However, these tasks are exemplary, and the scope of the present disclosure is not limited thereby.

## Technical Solution

A resonant cavity structure according to an embodiment of the present disclosure includes an upper layer in which first dielectric layers and second dielectric layers having different refractive indices are alternately stacked, a lower layer in which the first dielectric layers and the second dielectric layers are alternately stacked, and a cavity formed between the upper layer and the lower layer, wherein the cavity includes a wavelength conversion material that absorbs light having a first wavelength and emits light having a second wavelength different from the first wavelength, the resonant cavity structure is designed so that resonance occurs in the cavity at the first wavelength, and the resonant cavity structure may be provided so that an excitation light of the first wavelength is incident from below the lower layer.

## Advantageous Effects

According to one embodiment of the present disclosure made as described above, color conversion efficiency of a wavelength conversion material may be improved through an optical structure.

A resonant cavity structure including a wavelength conversion material (e.g., phosphor) according to an embodiment of the present disclosure may have a simple structure in which thin films are stacked on a plane, and thus may be easily fabricated and applied to devices. For example, the resonant cavity structure may be fabricated with repetitive thin film coatings of dielectric materials, which facilitates processing and enables mass production.

Of course, the scope of present disclosure is not limited by these effects. Description of Drawings

FIG. 1 is a diagram for explaining excitation light, transmitted light and color-converted light for a general wavelength conversion material.

FIG. 2 is a diagram for explaining excitation light, transmitted light and color-converted light for a resonant cavity structure according to an embodiment of present disclosure.

FIGS. 3A and 3B are views for explaining a resonant cavity structure according to another embodiment of present disclosure.

FIG. 4 illustrates an example of a schematic structure of a distributed Bragg reflector and its reflectance spectrum S1.

FIG. 5 illustrates an example of a schematic structure of a resonant cavity structure according to an embodiment of the present disclosure and its reflectance spectrum.

FIG. 6 illustrates an environment for simulating transmittance, absorptivity and reflectance of a resonant cavity structure according to an embodiment of the present disclosure.

FIG. 7 is a simulation result of the transmittance, the absorptivity and the reflectance of the resonant cavity structure in the same environment as in FIG. 6.

FIG. 8 is simulation results of transmittance, absorptivity, and reflectance of resonant cavity structures according to various embodiments of the present disclosure.

FIG. 9 illustrates a schematic structure of a resonant cavity structure according to another embodiment of the present disclosure.

FIG. 10 illustrates a schematic structure of a resonant cavity structure according to another embodiment of the present disclosure.

## Best Mode

A resonant cavity structure according to an embodiment of the present disclosure includes an upper layer in which first dielectric layers and second dielectric layers having different refractive indices are alternately stacked, a lower layer in which the first dielectric layers and the second dielectric layers are alternately stacked, and a cavity formed between the upper layer and the lower layer, wherein the cavity includes a wavelength conversion material that absorbs light having a first wavelength and emits light having a second wavelength different from the first wavelength, the resonant cavity structure is designed so that resonance occurs in the cavity at the first wavelength, and the resonant cavity structure may be provided so that an excitation light of the first wavelength is incident from below the lower layer.

According to one embodiment, the second wavelength may lie outside a stopband of the resonant cavity structure.

According to one embodiment, the second wavelength may be longer than the first wavelength.

According to one embodiment, the stopband of the resonant cavity structure may be formed at a band having a shorter wavelength than the second wavelength.

According to one embodiment, the refractive index of the first dielectric layer is smaller than a refractive index of the cavity containing the wavelength conversion material, and the refractive index of the second dielectric layer may be greater than the refractive index of the cavity containing the wavelength conversion material.

According to one embodiment, a layer located at a bottom of the lower layer may be the first dielectric layer.

According to one embodiment, a layer located on a top of the upper layer may be the second dielectric layer.

According to one embodiment, a dielectric layer in contact with the cavity in the upper layer and a dielectric layer in contact with the cavity in the lower layer are the same dielectric layer, and a thickness of the cavity may be $n/(2n_c)$ times a length of the first wavelength when n is a natural number and $n_c$ is the refractive index of the cavity.

According to one embodiment, a dielectric layer in contact with the cavity in the upper layer and a dielectric layer in contact with the cavity in the lower layer are different dielectric layers, and a thickness of the cavity may be $n/(4n_c)$ times a length of the first wavelength when n is an odd number and $n_c$ is the refractive index of the cavity.

According to one embodiment, the resonant cavity structure may further include a reflective layer disposed under the lower layer and allowing passage of light of the first wavelength and reflecting light of the second wavelength.

According to one embodiment, the cavity may further include a first wavelength conversion material absorbing light of the first wavelength and emitting light of the second wavelength, and a second wavelength conversion material absorbing light of the first wavelength and emitting light of a third wavelength.

According to one embodiment, the cavity may include a first layer in which the first wavelength conversion material is distributed, a second layer in which the second wavelength conversion material is distributed, and a third dielectric layer disposed between the first layer and the second layer.

According to one embodiment, a thickness of the cavity may gradually change along one direction intersecting a thickness direction of the cavity.

According to one embodiment, a thickness of the cavity may periodically change along one direction intersecting a thickness direction of the cavity.

According to one embodiment, a thickness of the first dielectric layer or a thickness of the second dielectric layer may gradually change as a number of alternations increases with respect to the upper layer or the lower layer.

According to one embodiment, the refractive index of the first dielectric layer or the refractive index of the second dielectric layer may gradually change as a number of alternations increases with respect to the upper layer or the lower layer.

According to one embodiment, an upper or lower surface of the resonant cavity structure may include a concave portion or a convex portion.

According to one embodiment, the upper or lower surface of the resonant cavity structure includes a plurality of concave portions or a plurality of convex portions, and the plurality of concave portions or the plurality of convex portions may be regularly arranged.

A light emitting structure according to one embodiment of the present disclosure includes a resonant cavity structure including an upper layer in which first dielectric layers and second dielectric layers having different refractive indices are alternately stacked, a lower layer in which the first dielectric layers and the second dielectric layers are alternately stacked, and a cavity formed between the upper layer and the lower layer, and a light emitting constitution or light emitting element disposed below the lower layer and generating excitation light of a first wavelength, wherein the cavity includes a wavelength conversion material that absorbs light having the first wavelength and emits light having a second wavelength different from the first wavelength, and the resonant cavity structure may be designed so that resonance occurs in the cavity at the first wavelength.

According to one embodiment, the second wavelength may lie outside a stopband of the resonant cavity structure.

According to one embodiment, the second wavelength may be longer than the first wavelength.

According to one embodiment, the stopband of the resonant cavity structure may be formed at a band having a shorter wavelength than the second wavelength.

According to one embodiment, the refractive index of the first dielectric layer is smaller than a refractive index of the cavity, the refractive index of the second dielectric layer is greater than the refractive index of the cavity, and a layer located at a bottom of the lower layer may be the first dielectric layer.

According to one embodiment, the refractive index of the first dielectric layer is smaller than a refractive index of the cavity, the refractive index of the second dielectric layer is greater than the refractive index of the cavity, and a layer located on a top of the upper layer may be the second dielectric layer.

According to one embodiment, the cavity may further include a first wavelength conversion material absorbing light of the first wavelength and emitting light of the second wavelength, and a second wavelength conversion material absorbing light of the first wavelength and emitting light of a third wavelength.

According to one embodiment, the cavity may include a first layer in which the first wavelength conversion material is distributed, a second layer in which the second wavelength conversion material is distributed, and a third dielectric layer disposed between the first layer and the second layer.

Other aspects, features and advantages other than those described above will become apparent from the following detailed description of the drawings, claims and disclosure.

Mode for Invention

Since the present disclosure may apply various transformations and may have various embodiments, specific embodiments are illustrated in the drawings and described in detail. Effects and characteristics of the present disclosure, and methods for achieving them will become clearer with reference to the embodiments described later in detail with drawings. However, the present disclosure is not limited to the embodiments disclosed below and may be implemented in various forms.

Hereinafter, embodiments of the present disclosure will be described in detail with reference to the accompanying drawings, and when describing with reference to the drawings, the same or corresponding components are given the same reference numerals, and overlapping descriptions thereof will be omitted.

In the following embodiments, terms such as first and second are used for the purpose of distinguishing one component from another component without limiting meaning.

In the following examples, expressions in the singular number include plural expressions unless the context clearly dictates otherwise.

In the following embodiments, terms such as include or have mean that features or elements described in the specification exist, and do not preclude the possibility that one or more other features or elements may be added.

In the drawings, the size of components may be exaggerated or reduced for convenience of explanation. For example, since the size and thickness of each component shown in the drawings are arbitrarily shown for convenience of explanation, the present disclosure is not necessarily limited to the illustrated ones.

In the following embodiments, when a part such as a region, component, layer, etc. is said to be on or on another part, not only the case directly above another part, but also the case where another region, component, layer, etc. is interposed therebetween is included.

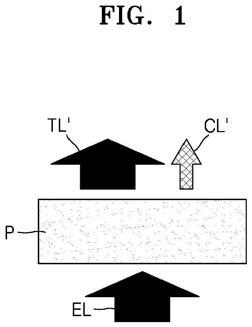

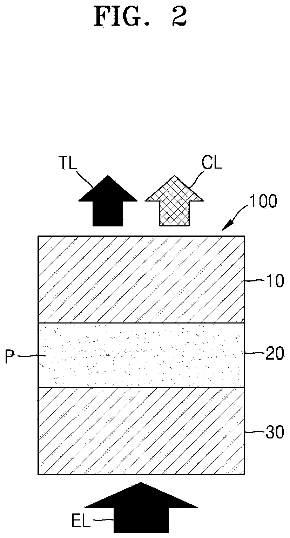

FIG. 1 is a diagram for explaining excitation light EL, transmitted light TL' and color-converted light CL' for a general wavelength conversion material P, and FIG. 2 is a diagram for explaining excitation light EL, transmitted light TL, and color-converted light CL for a resonant cavity structure 100 according to an embodiment of present disclosure.

First, referring to FIG. 1, excitation light EL is irradiated on a general wavelength conversion material P, the wavelength conversion material P absorbs a part of the excitation light EL, and may emit color-converted light CL'. The wavelength conversion material P may be, for example, a phosphor that absorbs excitation light EL of high energy (i.e., shorter wavelength) and emits color-converted light CL' of low energy (i.e., longer wavelength). However, it is not limited thereto, and the wavelength conversion material P may be nanoparticles that change excitation light EL of longer wavelength to color-converted light CL' of shorter wavelength by photon upconversion.

The color-converted light CL' may be emitted in all directions. Meanwhile, among the excitation light EL, light remaining after being absorbed by the wavelength conversion material P may be transmitted as the transmitted light TL'.

In comparison, referring to FIG. 2, a resonant cavity structure 100 according to an embodiment of the present disclosure includes an upper layer 10, a lower layer 30, and a cavity 20 formed between the lower layer 30 and the upper layer 10 and containing a wavelength conversion material P.

The wavelength conversion material P may absorb light having a first wavelength and emit light having a second wavelength longer or shorter than the first wavelength. When the wavelength conversion material P is a common phosphor, the second wavelength may be longer than the first wavelength. When the wavelength conversion material P is an upconverting nanoparticle, the second wavelength may be shorter than the first wavelength.

Hereinafter, a wavelength of the excitation light that excites the wavelength conversion material P will be referred to as the first wavelength, and a wavelength of the color-converted light emitted from the wavelength conversion material will be referred to as the second wavelength.

The resonant cavity structure 100 according to an embodiment of the present disclosure may be designed so that resonance occurs at the first wavelength.

For example, each of the upper layer 10 and the lower layer 30 may be a reflector that reflects light in a predetermined range including the first wavelength, and a thickness of the cavity 20 may satisfy a predetermined condition. When the resonant cavity structure 100 satisfies the predetermined conditions, resonance of light of the first wavelength may occur in the cavity 20.

When the resonant cavity structure 100 is irradiated with excitation light EL, the wavelength conversion material P contained in the cavity 20 may absorb a part of the excitation light EL and emit color-converted light CL. The color-converted light CL may be emitted in all directions. Among the excitation light EL, light remaining after being absorbed by the wavelength conversion material P may be transmitted out of the resonant cavity structure 100 as transmitted light TL. The excitation light EL and the transmitted light TL may have the above-described first wavelength, and the color-converted light CL may have the second wavelength.

Referring to FIGS. 1 and 2 together, comparing the case of irradiating the same excitation light EL to the general wavelength conversion material P and the resonant cavity structure 100 according to an embodiment of the present disclosure, more excitation light EL may be absorbed in the resonant cavity structure 100 including the wavelength conversion material P than the general wavelength conversion material P. In other words, an absorptivity for the first wavelength of the resonant cavity structure 100 including the wavelength conversion material P may be higher than an absorptivity for the first wavelength of the general wavelength conversion material P.

Therefore, an intensity of the color-converted light CL emitted from the resonant cavity structure 100 including the wavelength conversion material P may be greater than an intensity of the color-converted light CL' emitted from the general wavelength conversion material P. In addition, an intensity of the transmitted light TL in the resonant cavity structure 100 including the wavelength conversion material P may be smaller than an intensity of the transmitted light TL' in the general wavelength conversion material P.

Therefore, according to an embodiment of the present disclosure, when the excitation light EL is blue light and the wavelength conversion material P is a phosphor that absorbs the blue light and emits yellow or red light, the resonant cavity structure 100 may be used for a white light LED. In this case, a portion of the blue light may pass through the resonant cavity structure 100 as the transmitted light TL, and the other portion may pass through the resonant cavity structure 100 as the color-converted light CL of the yellow or red light after being absorbed by the phosphor.

Meanwhile, according to an embodiment of the present disclosure, each of the upper layer 10 and the lower layer 30 may be a distributed Bragg reflector (DBR).

In FIG. 2, a surface of the resonant cavity structure 100, specifically, the upper or lower surface is illustrated as having a planar structure, but the present disclosure is not limited thereto, and in another embodiment, the upper or lower surface of the resonant cavity structure 100 may be made of a shape including a concave portion or a convex portion. For example, the upper or lower surface of the resonant cavity structure 100 may include a plurality of concave portions or a plurality of convex portions, and may have a shape in which the plurality of concave portions or the plurality of convex portions are regularly arranged.

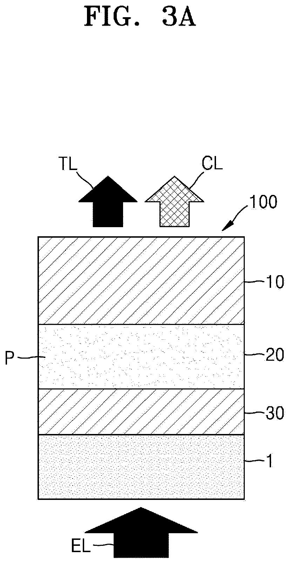

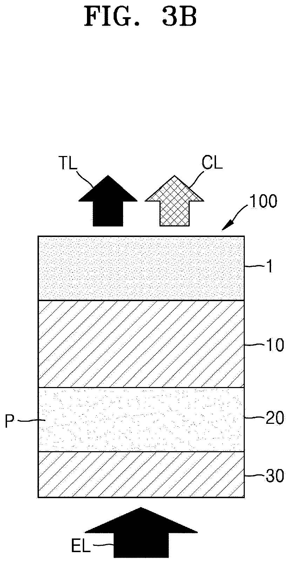

FIGS. 3A and 3B are views for explaining a resonant cavity structure 100 according to another embodiment of present disclosure.

Referring to FIGS. 3A and 3B, a resonant cavity structure 100 according to another embodiment includes an upper layer 10, a lower layer 30 and a cavity 20 formed between the upper layer 10 and the lower layer 30 and containing a wavelength conversion material P in the same manner as the resonant cavity structure 100 of FIG. 2, and may further include a substrate 1 provided on the upper layer 10 or the lower layer 30.

The substrate 1 is disposed between another element, for example, a device such as a light emitting element, and the resonant cavity structure 100, and may be made of a transmissive material. As an example, the substrate 1 may be made of a glass material. In this case, the resonant cavity structure 100 according to another embodiment may have different thicknesses of the upper layer 10 and the lower layer 30, unlike the resonant cavity structure of FIG. 2.

More specifically, the thickness of the lower layer 30 close to the excitation light EL may be thinner than the thickness of the upper layer 10. In this case, the substrate 1 may be disposed adjacent to the lower layer 30 as illustrated in FIG. 3A or disposed adjacent to the upper layer 10 as illustrated in FIG. 3B.

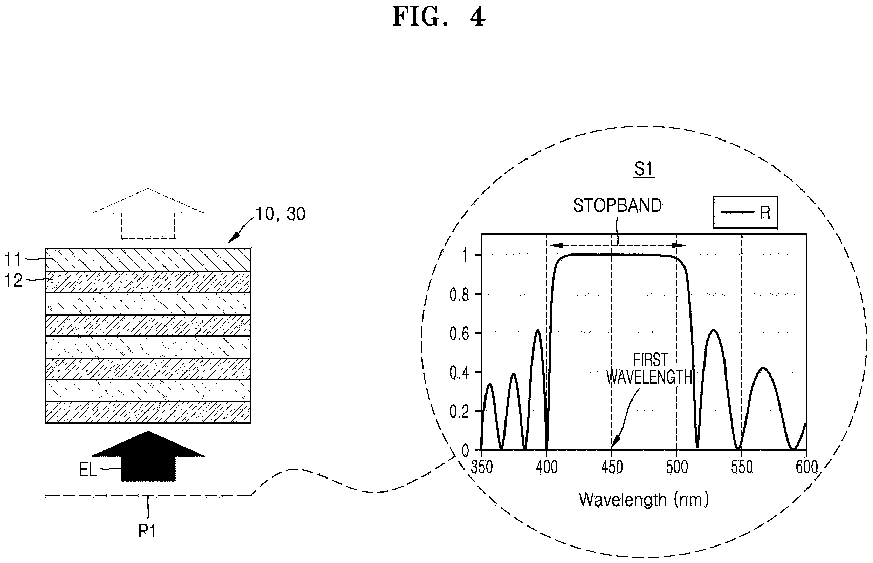

FIG. 4 illustrates an example of a schematic structure of a distributed Bragg reflector (DBR) and its reflectance spectrum S1. The distributed Bragg reflector may have a structure in which first dielectric layers 11 and second dielectric layers 12 having different refractive indices are alternately stacked.

Referring to FIG. 4, each of the upper layer 10 and the lower layer 30 according to an embodiment of the present disclosure may be formed of the distributed Bragg reflector. Each of the upper layer 10 and the lower layer 30 may have the structure in which the first dielectric layers 11 and the second dielectric layers 12 having different refractive indices are alternately stacked. In other words, each of the upper layer 10 and the lower layer 30 may have a structure in which the refractive index periodically changes.

The distributed Bragg reflector may be designed to reflect light in a specific wavelength range. A wavelength range (or frequency range) that is reflected is called a stopband. Light with a wavelength within the stopband is prevented from propagating in the distributed Bragg reflector.

In the present disclosure, the upper layer 10 and the lower layer 30 may be designed to have a stopband including the first wavelength. For example, it may be designed so that the stopband is formed at the first wavelength by adjusting the refractive index and thickness of the first dielectric layers 11 and the refractive index and thickness of the second dielectric layers 12 in the upper layer 10 and the lower layer 30.

As an example, the thickness of the first dielectric layers 11 or the thickness of the second dielectric layers 12 may gradually change as a number of alternations increases with respect to the upper layer 10 or the lower layer 30. In other words, the first dielectric layers 11 and the second dielectric layers 12 may be designed such that the alternating layers are not stacked with the same thickness, but the thickness of each layer gradually becomes thinner or thicker along a direction in which the number of alternations increases, when they are alternately stacked. Alternatively, the refractive index of the first dielectric layers 11 or the refractive index of the second dielectric layers 12 may gradually change as the number of alternations increases with respect to the upper layer 10 or the lower layer 30.

When the excitation light EL of the first wavelength is irradiated to the distributed Bragg reflector (DBR) 10 and 30 designed in this way, light may hardly be transmitted to the opposite side. FIG. 4 illustrates a situation in which there is no light transmitted over the DBR 10 and 30 when the excitation light EL is irradiated from below the DBR 10 and 30 toward the DBR 10 and 30.

The reflectance spectrum S1 of the DBR 10 and 30 is a graph simulating a spectrum of light intensity on a plane P1 under the DBR 10 and 30 when the excitation light EL is irradiated toward the DBR 10 and 30 from below the DBR 10 and 30.

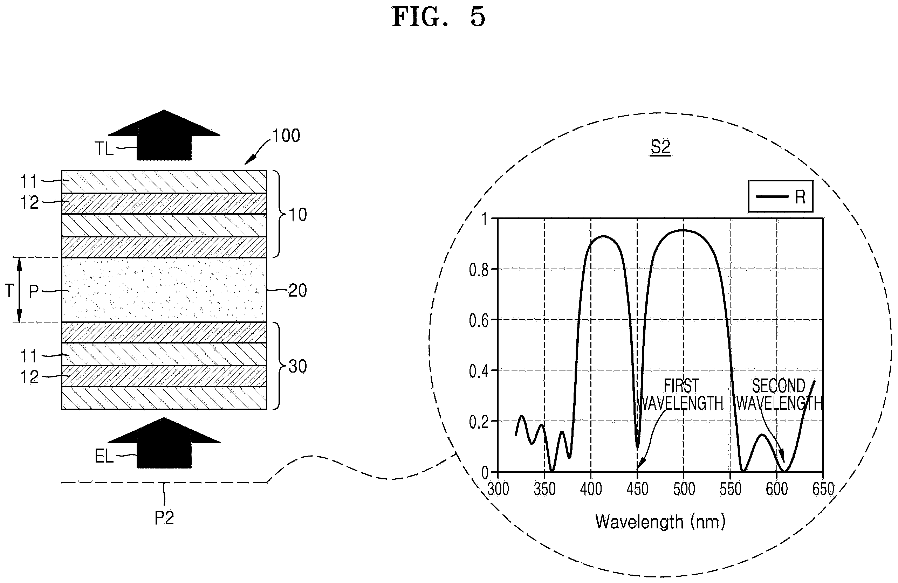

FIG. 5 illustrates an example of a schematic structure of a resonant cavity structure 100 according to an embodiment of the present disclosure and its reflectance spectrum S2.

Referring to FIG. 5, a resonant cavity structure 100 according to an embodiment of the present disclosure includes an upper layer 10 in which first dielectric layers 11 and second dielectric layers 12 having different refractive indices are alternately stacked, a lower layer 30 in which the first dielectric layers 11 and the second dielectric layers 12 are alternately stacked, and a cavity 20 formed between the upper layer 10 and the lower layer 30, and the cavity 20 includes a wavelength conversion material.

According to an embodiment of the present disclosure, the wavelength conversion material P may absorb light having a first wavelength and emit light having a second wavelength longer or shorter than the first wavelength. In addition, the resonant cavity structure 100 may be designed so that resonance occurs in the cavity 20 at the first wavelength.

The resonant cavity structure 100 according to an embodiment of the present disclosure may improve color conversion efficiency of the wavelength conversion material P from the first wavelength to the second wavelength. In various embodiments, the resonant cavity structure 100 may be applied to various light emitting elements by setting the first wavelength and the second wavelength as needed and using the appropriate excitation light EL and wavelength conversion material P. For example, the resonant cavity structure 100 including the wavelength conversion material (e.g., phosphor) that absorbs excitation light EL of blue light and emits yellow or red light may be applied to the white LED. However, the present disclosure is not limited thereto.

The resonant cavity structure 100 may cause strong resonance at a specific wavelength by including the cavity 20 between the upper layer 10 and the lower layer 30. Specifically, optical resonance may occur at the specific wavelength determined based on a thickness T and refractive index of the cavity 20. A detailed description of a condition of the thickness T of the cavity 20 for the optical resonance to occur at the first wavelength will be described later.

In an embodiment of the present disclosure, the thickness T of the cavity 20 may be determined so that resonance occurs in the cavity 20 at the first wavelength which is an absorption wavelength of the wavelength conversion material P. When resonance occurs in the cavity 20 at the first wavelength, at least some of the light of the first wavelength may be trapped in the cavity 20. Therefore, an absorptivity of the resonant cavity structure 100 increases at the first wavelength, so that the color conversion efficiency of the wavelength conversion material P may be improved.

As another example, the thickness T of the cavity 20 may change in one direction intersecting a thickness direction of the cavity 20, for example, along a planar direction of the resonant cavity structure 100. Specifically, the thickness of the cavity 20 may gradually change along the planar direction of the resonant cavity structure 100. Alternatively, the thickness of the cavity 20 may periodically change along the planar direction of the resonant cavity structure 100.

A reflectance spectrum S2 of the resonant cavity structure 100 is a graph simulating a spectrum of light intensity on a plane P2 under the resonant cavity structure 100 when the excitation light is generated from below the resonant cavity structure 100 toward the resonant cavity structure 100.

Compared to the reflectance spectrum S1 of the DBR 10 and 30 without the cavity, the reflectance spectrum S2 of the resonant cavity structure 100 with the cavity 20 formed between the upper layer 10 and the lower layer 30 may have a dip at the first wavelength.

Therefore, when the excitation light EL of the first wavelength is irradiated to the resonant cavity structure 100, a part of the light of the first wavelength is trapped in the cavity 20 and resonates, and the other part may exit the resonant cavity structure 100 as the transmitted light TL. Of course, some of the rest may be reflected. Therefore, an absorptivity of the resonant cavity structure 100 increases at the first wavelength, so that the color conversion efficiency of the wavelength conversion material P may be improved.

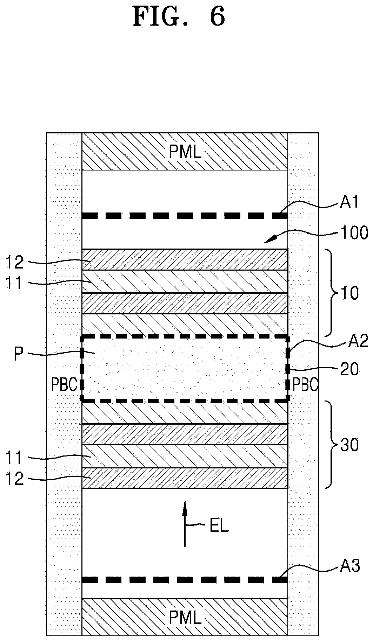

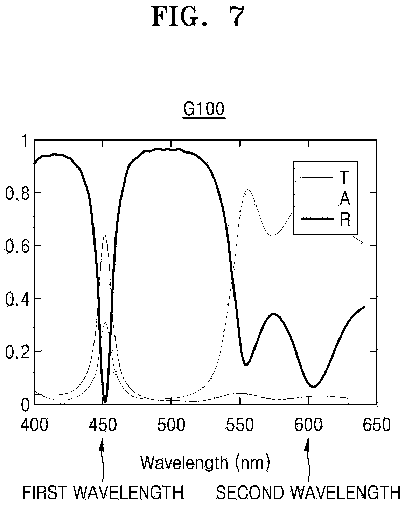

FIG. 6 illustrates an environment for simulating transmittance, absorptivity and reflectance of a resonant cavity structure 100 according to an embodiment of the present disclosure. FIG. 7 is a simulation result of the transmittance T, the absorptivity A and the reflectance R of the resonant cavity structure 100 in the same environment as in FIG. 6.

In a simulation environment illustrated in FIG. 6, it is assumed that the excitation light EL is radiated from below the resonant cavity structure 100 toward the resonant cavity structure 100. It is assumed that the excitation light EL is a plane wave. In the simulation environment, it is assumed that each of the lower surface and upper surface of the resonant cavity structure 100 is a perfectly matched layer (PML). In the simulation environment, it is assumed that side surfaces of the resonant cavity structure 100 are in periodic boundary condition (PBC).

Referring to FIGS. 6 and 7, a transmittance spectrum T of the resonant cavity structure 100 may be obtained based on a light spectrum in an upper area A1 of the resonant cavity structure 100 under the above simulation conditions. Under the simulation conditions, a reflectance spectrum R of the resonant cavity structure 100 may be obtained based on a light spectrum in a lower area A3 of the resonant cavity structure 100. In addition, an absorptivity spectrum A in a cavity area A2 may be obtained based on subtracting the transmittance spectrum T and the reflectance spectrum R from an excitation light EL spectrum.

A graph G100 in FIG. 7 is a simulation result of the transmittance spectrum T, the absorptivity spectrum A and the reflectance spectrum R of the resonant cavity structure 100 under the above conditions. The simulation may be, for example, a finite-difference time-domain (FDTD) simulation.

Here, the wavelength conversion material P contained in the cavity 20 is assumed to be red colloidal quantum dot (red CQD) (refractive index 1.82). In addition, a material of the first dielectric layers 11 is assumed to be $SiO_2$ (refractive index 1.46), and a material of the second dielectric layers 12 is assumed to be $SiN_4$ (refractive index 2.04). The resonant cavity structure 100 is designed so that resonance occurs in the cavity 20 at the set first wavelength. The first wavelength may be set to, for example, 450 nm, but is not limited thereto. The first wavelength is set to an absorption wavelength of the wavelength conversion material P according to characteristics of the wavelength conversion material P.

Specifically, the thickness of the first dielectric layers 11, the thickness of the second dielectric layers 12 and the thickness of the cavity 20 are set so as to resonate at the first wavelength and form the stopband around the first wavelength. For example, when the two dielectric layers in contact with the top and bottom of the cavity 20 are the same type of dielectric layer, the thickness T of the cavity 20 may be set to $n/(2n_c)$ times (n is a natural number, $n_c$ is the refractive index of the cavity 20) the first wavelength (e.g., 450 nm). As another example, when the refractive index of one dielectric layer of two dielectric layers in contact with the top and bottom of the cavity 20 is smaller than the refractive index of the cavity 20 and the refractive index of the other dielectric layer is greater than the refractive index of the cavity 20, the thickness T of the cavity 20 may be set to $n/(4n_c)$ times (n is an odd number, and $n_c$ is the refractive index of the cavity 20) the first wavelength (e.g., 450 nm).

Referring to the graph G100, a dip of the reflectance spectrum R may be formed at the set first wavelength. Accordingly, due to resonance at the first wavelength, a peak of the absorptivity spectrum A may be formed at the first wavelength. Also, referring to the transmittance spectrum T, it may be seen that a part of light is transmitted at the first wavelength.

Based on this, when the resonant cavity structure 100 containing the wavelength conversion material P is irradiated with the excitation light EL of the first wavelength, a part of the light of the first wavelength exits the resonant cavity structure 100 as it is, and the other part may exit the resonant cavity structure 100 after color conversion to the second wavelength by the wavelength conversion material P.

In one embodiment of the present disclosure, the color-converted light of the second wavelength must be able to pass through the distributed Bragg reflector (DBR) corresponding to the upper layer 10 well. Therefore, in one embodiment of the present disclosure, the stopband (i.e., a band having a reflectance close to 1) of the resonant cavity structure 100 may be formed not to include the second wavelength.

Hereinafter, conditions necessary for designing the resonant cavity structure 100 so that the stopband of the resonant cavity structure 100 does not include the second wavelength are described.

Equation 1 below is an equation representing a stopband width.

[Equation 1]

$$\Delta\lambda_{max} = \frac{4\lambda}{\pi} \sin^{-1}\left(\frac{n_H - n_L}{n_H + n_L}\right)$$

In Equation 1, $\Delta\lambda$max represents the stopband width, $\lambda$ represents a center wavelength of the stopband, $n_L$ represents the refractive index of the first dielectric layer 11 at the wavelength $\lambda$, and $n_H$ represents the refractive index of the second dielectric layer 12 at the wavelength $\lambda$. In the embodiments of the present disclosure, the center wavelength of the stopband is designed to match the first wavelength, which is the absorption wavelength of the wavelength conversion material P, so $\lambda$ becomes the first wavelength.

Referring to Equation 1, as a difference between the refractive index $n_L$ of the first dielectric layer 11 and the refractive index $n_H$ of the second dielectric layer 12 increases, the stopband width may increase. However, when the stopband width is too large, the stopband will include the second wavelength. When the stopband includes the second wavelength, propagation of light of the second wavelength is prohibited in the structure 100, so that the color-converted light may not easily exit the structure 100.

Therefore, according to an embodiment of the present disclosure, the difference between the refractive index of the first dielectric layer 11 and the refractive index of the second dielectric layer 12 may be set so that the stopband of the resonant cavity structure 100 does not include the second wavelength. In other words, the difference between the refractive index of the first dielectric layer 11 and the refractive index of the second dielectric layer 12 may be set such that the stopband of the resonant cavity structure 100 is formed in a band shorter or longer wavelength than the second wavelength.

According to an embodiment, the difference between the refractive index of the first dielectric layer 11 and the refractive index of the second dielectric layer 12 may be set to be smaller than a specified value.

According to one embodiment of the present disclosure, a number of pairs of the first dielectric layers 11 and the second dielectric layers 12 in the upper layer 10 and a number of pairs of the first dielectric layers 11 and the second dielectric layers 12 in the lower layer 30 may be 4 or more and 6 or less, respectively.

For example, as the number of pairs of the first dielectric layers 11 and the second dielectric layers 12 increases in the upper layer 10 and the lower layer 30, the stopband may be clearly defined. For example, as the number of pairs of the first dielectric layers 11 and the second dielectric layers 12 increases, the reflectance at a boundary of the stopband may change steeply. However, as the number of pairs increases, the reflectance of the structure 100 at the first wavelength increases, and the transmittance of the structure 100 at the first wavelength may decrease. For this reason, the absorptivity of the structure 100 at the first wavelength may be highest when the number of pairs in the upper layer 10 is 4 or more and 6 or less, and the number of pairs in the lower layer 30 is 4 or more and 6 or less. However, this is only one embodiment, and the present disclosure is not limited thereto.

According to one embodiment of the present disclosure, the number of pairs of the first dielectric layers 11 and the second dielectric layers 12 in the upper layer 10 and the number of pairs of the first dielectric layers 11 and the second dielectric layers 12 in the lower layer 30 may be different from each other. Also, according to an embodiment of the present disclosure, the number of pairs of the first dielectric layers 11 and the second dielectric layers 12 in the upper layer 10 or the lower layer 30 does not necessarily have to be an integer. For example, when the first dielectric layers 11 and the second dielectric layers 12 are 5 pairs in the upper layer 10, 5 first dielectric layers 11 and 5 second dielectric layers 12 may be alternately stacked on the upper layer 10. For example, when the first dielectric layers 11 and the second dielectric layers 12 are 4.5 pairs in the lower layer 30, 5 first dielectric layers 11 and 4 second dielectric layers 12 may be alternately stacked on the lower layer 30. However, this is only an example and the present disclosure is not limited thereto.

According to an embodiment of the present disclosure, a layer in the upper layer 10 that contacts the cavity 20 (i.e., a lowermost layer of the upper layer 10) may be the first dielectric layer 11 or the second dielectric layer 12. In addition, a layer in the lower layer 30 that contacts the cavity 20 (i.e., an uppermost layer of the lower layer 30) may also be the first dielectric layer 11 or the second dielectric layer 12.

Hereinafter, it is assumed that the refractive index of the first dielectric layer 11 is smaller than the refractive index of the cavity 20 and the refractive index of the second dielectric layer 12 is greater than the refractive index of the cavity 20.

In one embodiment, when the layer in contact with the cavity 20 is the second dielectric layer 12, a boundary between the cavity 20 and the second dielectric layer 12 becomes a fixed end, so that a node may be formed. In one embodiment, when the layer in contact with the cavity 20 is the first dielectric layer 11, a boundary between the cavity 20 and the first dielectric layer 11 becomes a free end, so that an antinode may be formed.

According to an embodiment, both the dielectric layer in contact with the cavity 20 in the upper layer 10 and the dielectric layer in contact with the cavity 20 in the lower layer 30 may all be the second dielectric layers 12. In this case, both an upper end and a lower end of the cavity 20 become the fixed ends, and a strong field may be formed in a center of the cavity 20.

According to another embodiment, the dielectric layer in contact with the cavity 20 in the upper layer 10 and the dielectric layer in contact with the cavity 20 in the lower layer 30 may all be the first dielectric layers 11. In this case, both the upper end and the lower end of the cavity 20 become the free ends, and a strong field may be formed at the upper end and the lower end of the cavity 20.

When the dielectric layer in contact with the cavity 20 in the upper layer 10 and the dielectric layer in contact with the cavity 20 in the lower layer 30 are the same types of the dielectric layers, in order to resonate at the first wavelength, the thickness T of the cavity 20 is $n/(2n_c)$ times (n is natural number, $n_c$ is the refractive index of the cavity 20) the first wavelength.

According to another embodiment, the dielectric layer in contact with the cavity 20 in the upper layer 10 and the dielectric layer in contact with the cavity 20 in the lower layer 30 may be different types of dielectric layers. In this case, in order to resonate at the first wavelength, the thickness T of the cavity 20 may be $n/(4n_c)$ times (n is an odd number, $n_c$ is the refractive index of the cavity 20) the first wavelength (e.g., 450 nm).

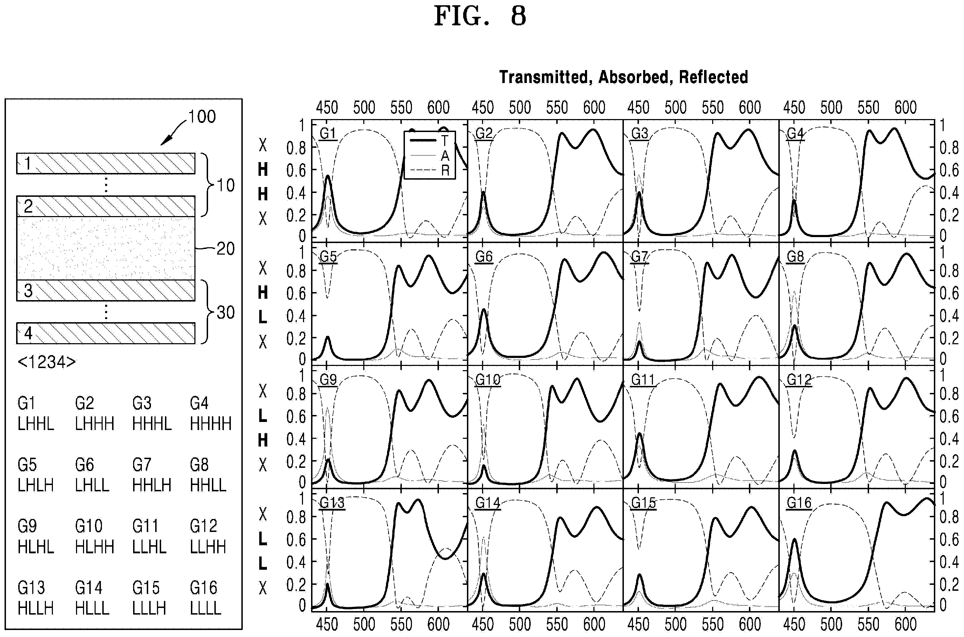

FIG. 8 is simulation results of transmittance T, absorptivity A and reflectance R of resonant cavity structures 100 according to various embodiments of the present disclosure.

In various embodiments of the present disclosure, it is assumed that the refractive index of the second dielectric layers 12 is greater than the refractive index of the first dielectric layers 11.

Referring to FIG. 8, in a resonant cavity structure 100 according to various embodiments of the present disclosure, an uppermost layer of a upper layer 10 (layer 1 in FIG. 8) and a lowermost layer of the upper layer 10 (layer 2 in FIG. 8), an uppermost layer of a lower layer 30 (layer 3 in FIG. 8) and a lowermost layer of the lower layer 30 (layer 4 in FIG. 8) may be the first dielectric layer 11 or the second dielectric layer 12, respectively. Graphs G1 to G16 illustrated in FIG. 8 are graphs of transmittance T, absorptivity A and light reflectance R for all of these cases.

In the notation of FIG. 8, L represents a low refractive index, that is, the first dielectric layer 11, and H represents a high refractive index, that is, the second dielectric layer 12.

For example, G1 is labeled LHHL, and is a simulation graph of a resonant cavity structure in which the layer 1 is the first dielectric layer 11, the layers 2 and 3 are the second dielectric layers 12, and the layer 4 is the first dielectric layer 11.

G2 is labeled LHHH, and is a simulation graph of the resonant cavity structure in which the layer 1 is the first dielectric layer 11, and the layers 2, 3 and 4 are all the second dielectric layers 12.

G3 is labeled as HHHL, and is a simulation graph of the resonant cavity structure in which the layers 1, 2 and 3 are all the second dielectric layers 12, and the layer 4 is the first dielectric layer 11.

Also, G1 to G4 in a first row are simulation graphs when the layers 2 and 3 are all the second dielectric layers 12.

G5 to G8 in a second row are simulation graphs when the layer 2 is second dielectric layer 12 and the layer 3 is the first dielectric layer 11.

G9 to G12 in a third row are simulation graphs when the layer 2 is the first dielectric layer 11 and the layer 3 is the second dielectric layer 12.

G13 to G16 in a fourth row are simulation graphs when the layers 2 and 3 are all the first dielectric layers 11.

According to one embodiment of the present disclosure, it may be preferable that the layer (layer 4) located at the bottom of the lower layer 30 is the first dielectric layer 11. This is because when the refractive index of the layer (layer 4) located at the bottom of the lower layer 30 is low, less excitation light may be reflected. Even referring to graphs G1 to G16, it may be seen that a deep dip in the reflectance spectrum occurs at the first wavelength when the layer 4 is the first dielectric layer 11 (G1, G3, G6, G8, G9, G11, G14 and G16). Therefore, in order to minimize the reflection of the excitation light and allow the excitation light to enter the structure 100 and resonate in the cavity 20 as much as possible, it may be desirable that the layer (layer 4) located at the bottom of the lower layer 30 be the first dielectric layer 11. However, the present disclosure is not limited thereto. In a resonant cavity structure 100 according to optional embodiments, the second dielectric layer 12 may be positioned at the bottom of the lower layer 30.

According to one embodiment of the present disclosure, the layer (layer 1) located on the top of the upper layer 10 may be the second dielectric layer 12. This is because when the refractive index of the layer (layer 1) located on the top of the upper layer 10 is high, absorption may increase due to less transmission. Even referring to graphs G1 to G16, it may be seen that the transmittance is small at the first wavelength when the layer 1 is the second dielectric layer 12 (G3, G4, G7, G8, G9, G10, G13 and G14). Therefore, in order to minimize transmission of the excitation light and to allow the excitation light to be confined inside the structure 100 and resonate in the cavity 20 as much as possible, it may be preferable that the layer (layer 1) located on the top of the upper layer 10 be the second dielectric layer 12. However, the present disclosure is not limited thereto.

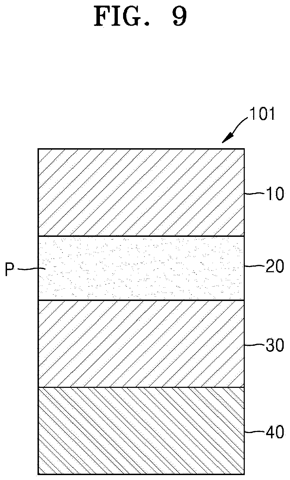

FIG. 9 illustrates a schematic structure of a resonant cavity structure 101 according to another embodiment of the present disclosure.

Referring to FIG. 9, a resonant cavity structure 101 according to another embodiment of the present disclosure, compared to the above-described resonant cavity structure 100, may further include a reflective layer 40 disposed on the side to which the excitation light is irradiated. Assuming that excitation light is irradiated from below the resonant cavity structure 100 and 101 corresponding to the above, the resonant cavity structure 101 may further include the reflective layer 40 below the lower layer 30, compared to the resonant cavity structure 100 described above.

Specifically, the resonant cavity structure 101 according to another embodiment of the present disclosure may include an upper layer 10, a lower layer 30, a cavity 20 formed between the upper layer 10 and the lower layer 30 and including a wavelength conversion material P, and the reflective layer 40 disposed below the lower layer 30. The wavelength conversion material P may absorb light of a first wavelength and emit light of a second wavelength. Each of the upper layer 10 and the lower layer 30 may have a structure that reflects light of the first wavelength. The cavity 20 between the upper layer 10 and the lower layer 30 may be formed so that light of the first wavelength resonates. In addition, the reflective layer 40 disposed below the lower layer 30 may have a structure that reflects light of the second wavelength. The excitation light may be irradiated from below the reflective layer 40 toward the resonant cavity structure 101.

According to an embodiment, each of the upper layer 10 and the lower layer 30 may be a distributed Bragg reflector (DBR) that reflects light of the first wavelength. Also, the reflective layer 40 may be a distributed Bragg reflector (DBR) that reflects light of the second wavelength. A stopband of the reflective layer 40 may be formed not to include the first wavelength. That is, the stopband of the reflective layer 40 may be formed in a band longer or shorter wavelength than the first wavelength. For this reason, a light spectrum near the first wavelength of the resonant cavity structure 101 to which the reflective layer 40 is added may be similar to a light spectrum near the first wavelength of the resonant cavity structure 100 described above. That is, even when the reflective layer 40 is added, the reflective layer 40 may be designed so that there is little decrease in the transmittance, the absorptivity and the reflectance at the first wavelength. On the other hand, due to the presence of the reflective layer 40 that reflects light of the second wavelength, an intensity of a color-converted light of the second wavelength exiting the top may be further enhanced.

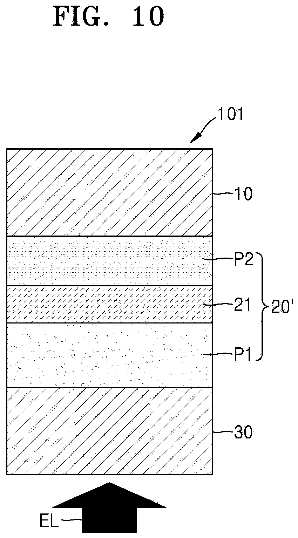

FIG. 10 illustrates a schematic structure of a resonant cavity structure 102 according to another embodiment of the present disclosure.

Referring to FIG. 10, a cavity 20' of a resonant cavity structure 102 according to another embodiment of the present disclosure may include a first wavelength conversion material P1 and a second wavelength conversion material P2.

According to one embodiment, the cavity 20' may include a first layer in which the first wavelength conversion material P1 is distributed, a second layer in which the second wavelength conversion material P2 is distributed, and a third dielectric layer 21 disposed between the first layer and the second layer.

According to an embodiment, the first wavelength conversion material P1 may absorb light of a first wavelength, which is a wavelength of excitation light EL, and emit light of a second wavelength. The second wavelength conversion material P2 may absorb light of the first wavelength and emit light of a third wavelength.

According to one embodiment, the first wavelength conversion material P1 is a first phosphor that absorbs light of the first wavelength and emits light of the second wavelength that is a longer wavelength than the first wavelength, and the second wavelength conversion material P2 may be a second phosphor that absorbs light of the first wavelength and emits light of the third wavelength that is a longer wavelength than the first wavelength. In this case, when the excitation light EL is irradiated from below the resonant cavity structure 102 and the first layer including the first phosphor is disposed below the second layer including the second phosphor, the second wavelength, which is an emission wavelength of the first phosphor, may be a longer wavelength than the third wavelength, which is an emission wavelength of the second phosphor. In this way, light of the second wavelength converted by the first phosphor may not be reabsorbed by the second phosphor.

An upper layer 10 and a lower layer 30 of the resonant cavity structure 102 according to the embodiment illustrated in FIG. 10 may correspond to the upper layer 10 and the lower layer 30 described above.

The present disclosure may further include the resonant cavity structures 100, 101 and 102 according to various embodiments, and a light emitting structure including a light emitting layer disposed under the resonant cavity structures 100, 101 and 102 and emitting the excitation light (not illustrated). The light emitting layer may be, for example, a light emitting constitution or a light emitting element (e.g., LED, etc.). Therefore, the light emitting structure according to an embodiment of the present disclosure may include the resonant cavity structures 100, 101 and 102 and the light emitting constitution or the light emitting element (e.g., LED, etc.) disposed under the resonant cavity structures 100, 101 and 102 and generating the excitation light of the first wavelength.

The present disclosure has been described with reference to an embodiment shown in the drawings, but this is only exemplary, and those skilled in the art will understand that various modifications and variations of the embodiment are possible therefrom. Therefore, the true technical protection scope of the present disclosure should be determined by the technical spirit of the appended claims.

Industrial Applicability

According to one embodiment of the present disclosure, a resonant cavity structure is provided. In addition, embodiments of the present disclosure may be applied to various fields requiring color conversion, such as lighting or display.

**Claims**

1. A resonant cavity structure comprising:

    an upper layer in which first dielectric layers and second dielectric layers having different refractive indices are alternately stacked;
    a lower layer in which the first dielectric layers and the second dielectric layers are alternately stacked; and
    a cavity formed between the upper layer and the lower layer,
    wherein the cavity comprises a wavelength conversion material that absorbs light having a first wavelength and emits light having a second wavelength different from the first wavelength,
    the resonant cavity structure is designed so that resonance occurs in the cavity at the first wavelength, and
the resonant cavity structure is provided so that an excitation light of the first wavelength is incident from below the lower layer.

2. The resonant cavity structure of claim 1, wherein the second wavelength lies outside a stopband of the resonant cavity structure.

3. The resonant cavity structure of claim 1, wherein the second wavelength is longer than the first wavelength.

4. The resonant cavity structure of claim 3, wherein the stopband of the resonant cavity structure is formed at a band having a shorter wavelength than the second wavelength.

5. The resonant cavity structure of claim 1,

wherein the refractive index of the first dielectric layer is smaller than a refractive index of the cavity containing the wavelength conversion material, and
the refractive index of the second dielectric layer is greater than the refractive index of the cavity containing the wavelength conversion material.

6. The resonant cavity structure of claim 5, wherein a layer located at a bottom of the lower layer is the first dielectric layer.

7. The resonant cavity structure of claim 5, wherein a layer located on a top of the upper layer is the second dielectric layer.

8. The resonant cavity structure of claim 1,

wherein a dielectric layer in contact with the cavity in the upper layer and a dielectric layer in contact with the cavity in the lower layer are the same dielectric layer, and
a thickness of the cavity is $n/(2n_c)$ times a length of the first wavelength when n is a natural number and $n_c$ is the refractive index of the cavity.

9. The resonant cavity structure of claim 1,

wherein a dielectric layer in contact with the cavity in the upper layer and a dielectric layer in contact with the cavity in the lower layer are different dielectric layers, and
a thickness of the cavity is $n/(4n_c)$ times a length of the first wavelength when n is an odd number and $n_c$ is the refractive index of the cavity.

10. The resonant cavity structure of claim 1, further comprising

a reflective layer disposed under the lower layer and allowing passage of light of the first wavelength and reflecting light of the second wavelength.

11. The resonant cavity structure of claim 1,

wherein the cavity further comprises
a first wavelength conversion material absorbing light of the first wavelength and emitting light of the second wavelength, and
a second wavelength conversion material absorbing light of the first wavelength and emitting light of a third wavelength.

12. The resonant cavity structure of claim 11, wherein the cavity includes a first layer in which the first wavelength conversion material is distributed, a second layer in which the second wavelength conversion material is distributed, and a third dielectric layer disposed between the first layer and the second layer.

13. The resonant cavity structure of claim 1, wherein a thickness of the cavity gradually changes along one direction intersecting a thickness direction of the cavity.

14. The resonant cavity structure of claim 1, wherein a thickness of the cavity periodically changes along one direction intersecting a thickness direction of the cavity.

15. The resonant cavity structure of claim 1, wherein a thickness of the first dielectric layer or a thickness of the second dielectric layer gradually changes as a number of alternations increases with respect to the upper layer or the lower layer.

16. The resonant cavity structure of claim 1, wherein the refractive index of the first dielectric layer or the refractive index of the second dielectric layer gradually changes as a number of alternations increases with respect to the upper layer or the lower layer.

17. The resonant cavity structure of claim 1, wherein an upper or lower surface of the resonant cavity structure includes a concave portion or a convex portion.

18. The resonant cavity structure of claim 17,

wherein the upper or lower surface of the resonant cavity structure includes a plurality of concave portions or a plurality of convex portions, and
the plurality of concave portions or the plurality of convex portions are regularly arranged.

19. A light emitting structure comprising:

a resonant cavity structure including an upper layer in which first dielectric layers and second dielectric layers having different refractive indices are alternately stacked, a lower layer in which the first dielectric layers and the second dielectric layers are alternately stacked, and a cavity formed between the upper layer and the lower layer; and
a light emitting constitution or light emitting element disposed below the lower layer and generating excitation light of a first wavelength,
wherein the cavity includes a wavelength conversion material that absorbs light having the first wavelength and emits light having a second wavelength different from the first wavelength, and
the resonant cavity structure is designed so that resonance occurs in the cavity at the first wavelength.

20. The light emitting structure of claim 19, wherein the second wavelength lies outside a stopband of the resonant cavity structure.

21. The light emitting structure of claim 19, wherein the second wavelength is longer than the first wavelength.

22. The light emitting structure of claim 21, wherein the stopband of the resonant cavity structure is formed at a band having a shorter wavelength than the second wavelength.

23. The light emitting structure of claim 19,

wherein the refractive index of the first dielectric layer is smaller than a refractive index of the cavity, the refractive index of the second dielectric layer is greater than the refractive index of the cavity, and
a layer located at a bottom of the lower layer is the first dielectric layer.

24. The light emitting structure of claim 19,

wherein the refractive index of the first dielectric layer is smaller than a refractive index of the cavity, the refractive index of the second dielectric layer is greater than the refractive index of the cavity, and
a layer located on a top of the upper layer is the second dielectric layer.

25. The light emitting structure of claim 19,

wherein the cavity further comprises
a first wavelength conversion material absorbing light of the first wavelength and emitting light of the second wavelength, and
a second wavelength conversion material absorbing light of the first wavelength and emitting light of a third wavelength.

26. The light emitting structure of claim 25, wherein the cavity includes a first layer in which the first wavelength conversion material is distributed, a second layer in which the second wavelength conversion material is distributed, and a third dielectric layer disposed between the first layer and the second layer.

# FIG. 1

# FIG. 2

FIG. 3A

# FIG. 3B

FIG. 4

EP 4 246 600 A1

FIG. 5

# FIG. 6

# FIG. 7

G100

FIRST WAVELENGTH   SECOND WAVELENGTH

FIG. 8

Transmitted, Absorbed, Reflected

# FIG. 9

# FIG. 10

## INTERNATIONAL SEARCH REPORT

| | International application No. |
|---|---|
| | **PCT/KR2021/016222** |

**A. CLASSIFICATION OF SUBJECT MATTER**

**H01L 33/50**(2010.01)i; **H01L 33/60**(2010.01)i

According to International Patent Classification (IPC) or to both national classification and IPC

**B. FIELDS SEARCHED**

Minimum documentation searched (classification system followed by classification symbols)

H01L 33/50(2010.01); B82Y 20/00(2011.01); G01J 3/44(2006.01); G02B 5/28(2006.01); H01L 33/00(2010.01); H01S 5/183(2006.01); H01S 5/187(2006.01); H01S 5/347(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 유전체(dielectric), 공동(cavity), 파장(wavelength), 변환(transform), 공진 (resonance)

**C. DOCUMENTS CONSIDERED TO BE RELEVANT**

| Category* | Citation of document, with indication, where appropriate, of the relevant passages | Relevant to claim No. |
|---|---|---|
| X | JP 2014-517520 A (BURLEY'S TECHNOLOGIES LLC) 17 July 2014 (2014-07-17)<br>See paragraphs [0017], [0025]-[0026], [0029], [0031], [0035]-[0036], [0038], [0049], [0066] and [0069]; claims 1 and 33; and figure 12. | 1,5-9,11-14,19,23-26 |
| Y | | 2-4,10,17-18,20-22 |
| A | | 15-16 |
| Y | US 2014-0151575 A1 (HILLMER, Hartmut et al.) 05 June 2014 (2014-06-05)<br>See paragraph [0039]; and figure 2. | 2-4,20-22 |
| Y | JP 2010-040976 A (SONY CORP.) 18 February 2010 (2010-02-18)<br>See paragraphs [0055]-[0061]; claim 1; and figure 1. | 10 |
| Y | KR 10-2016-0126059 A (KONINKLIJKE PHILIPS N.V.) 01 November 2016 (2016-11-01)<br>See paragraphs [0035]-[0036]; and figures 8-9. | 17-18 |

☑ Further documents are listed in the continuation of Box C.      ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **25 February 2022** | **25 February 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**

International application No.

**PCT/KR2021/016222**

C.    DOCUMENTS CONSIDERED TO BE RELEVANT

| Category* | Citation of document, with indication, where appropriate, of the relevant passages | Relevant to claim No. |
|---|---|---|
| A | KR 10-0668328 B1 (SAMSUNG ELECTRONICS CO., LTD.) 12 January 2007 (2007-01-12) See paragraphs [0026]-[0034]; and figure 1. | 1-26 |

Form PCT/ISA/210 (second sheet) (July 2019)

<table>
<tr><td colspan="2" align="center">INTERNATIONAL SEARCH REPORT<br>Information on patent family members</td><td colspan="2">International application No.<br><br>**PCT/KR2021/016222**</td></tr>
<tr><td>Patent document<br>cited in search report</td><td>Publication date<br>(day/month/year)</td><td>Patent family member(s)</td><td>Publication date<br>(day/month/year)</td></tr>
<tr><td>JP      2014-517520      A</td><td>17 July 2014</td><td>CN      103620894      A</td><td>05 March 2014</td></tr>
<tr><td></td><td></td><td>EP      2710695      A1</td><td>26 March 2014</td></tr>
<tr><td></td><td></td><td>JP      6129160      B2</td><td>17 May 2017</td></tr>
<tr><td></td><td></td><td>KR  10-2014-0046419      A</td><td>18 April 2014</td></tr>
<tr><td></td><td></td><td>US      2014-0055845      A1</td><td>27 February 2014</td></tr>
<tr><td></td><td></td><td>US      2015-0192714      A1</td><td>09 July 2015</td></tr>
<tr><td></td><td></td><td>US      9019595      B2</td><td>28 April 2015</td></tr>
<tr><td></td><td></td><td>US      9354366      B2</td><td>31 May 2016</td></tr>
<tr><td></td><td></td><td>WO      2012-158256      A1</td><td>22 November 2012</td></tr>
<tr><td>US      2014-0151575      A1</td><td>05 June 2014</td><td>CN      101627289      A</td><td>13 January 2010</td></tr>
<tr><td></td><td></td><td>CN      104316987      A</td><td>28 January 2015</td></tr>
<tr><td></td><td></td><td>EP      2057446      A2</td><td>13 May 2009</td></tr>
<tr><td></td><td></td><td>US      2011-0043823      A1</td><td>24 February 2011</td></tr>
<tr><td></td><td></td><td>US      8629986      B2</td><td>14 January 2014</td></tr>
<tr><td></td><td></td><td>US      9244208      B2</td><td>26 January 2016</td></tr>
<tr><td></td><td></td><td>WO      2008-017490      A2</td><td>14 February 2008</td></tr>
<tr><td></td><td></td><td>WO      2008-017490      A3</td><td>26 June 2008</td></tr>
<tr><td>JP      2010-040976      A</td><td>18 February 2010</td><td>None</td><td></td></tr>
<tr><td>KR  10-2016-0126059      A</td><td>01 November 2016</td><td>CN      106030837      A</td><td>12 October 2016</td></tr>
<tr><td></td><td></td><td>CN      106030837      B</td><td>05 May 2020</td></tr>
<tr><td></td><td></td><td>EP      3111487      A1</td><td>04 January 2017</td></tr>
<tr><td></td><td></td><td>EP      3111487      B1</td><td>11 March 2020</td></tr>
<tr><td></td><td></td><td>JP      2017-506833      A</td><td>09 March 2017</td></tr>
<tr><td></td><td></td><td>JP      6715773      B2</td><td>01 July 2020</td></tr>
<tr><td></td><td></td><td>KR      10-2328495      B1</td><td>17 November 2021</td></tr>
<tr><td></td><td></td><td>US      2017-0012183      A1</td><td>12 January 2017</td></tr>
<tr><td></td><td></td><td>US      2017-0331011      A1</td><td>16 November 2017</td></tr>
<tr><td></td><td></td><td>US      9666771      B2</td><td>30 May 2017</td></tr>
<tr><td></td><td></td><td>WO      2015-128750      A1</td><td>03 September 2015</td></tr>
<tr><td>KR      10-0668328      B1</td><td>12 January 2007</td><td>JP      2006-229194      A</td><td>31 August 2006</td></tr>
<tr><td></td><td></td><td>KR  10-2006-0091509      A</td><td>21 August 2006</td></tr>
<tr><td></td><td></td><td>US      2006-0227837      A1</td><td>12 October 2006</td></tr>
<tr><td></td><td></td><td>US      2008-0227230      A1</td><td>18 September 2008</td></tr>
</table>

Form PCT/ISA/210 (patent family annex) (July 2019)